# EUROPEAN PATENT SPECIFICATION

(11) **EP 0 623 926 B1**
(45) Date of publication and mention of the grant of the patent: **12.08.1998**
(21) Application number: 94201228.7
(22) Date of filing: 03.05.1994
(51) Int. Cl.: G11B 20/10, G11B 20/20, G11B 15/52

(54) **Arrangement for reproducing n digital signals from n adjacent tracks on a record carrier**
Einrichtung zur Wiedergabe von n digitalen Signalen aus n angrenzenden Spuren auf einem Aufzeichnungsträger
Dispositif de lecture de n signaux numériques de n pistes adjacentes sur un support d'enregistrement

(30) Priority: 07.05.1993 EP 93201327
(43) Date of publication of application: 09.11.1994
(73) Proprietor: PHILIPS ELECTRONICS N.V., 5621 BA Eindhoven (NL)
(72) Inventor: Kalfs, Johannes Jozef Wilhelmus, NL-5656 AA Eindhoven (NL); Kneepkens, Franciscus Antonius, NL-5656 AA Eindhoven (NL)
(74) Representative: van der Kruk, Willem Leonardus

(56) References cited:
- EP-A- 0 267 035
- FR-A- 2 497 429
- PATENT ABSTRACTS OF JAPAN vol. 10, no. 160 (P-465) (2216) 7 June 1986 & JP-A-61 011 973
- IBM TECHNICAL DISCLOSURE BULLETIN., vol.34, no.7A, December 1991, ARMONK, NEW YORK US pages 315 - 316, XP000255561 'WRITE DATE CIRCUITS WITH SAMPLE SECTOR SERVO'

## Description

The invention relates to an arrangement for reproducing n digital signals from n adjacent tracks on a record carrier, which arrangement comprises
- read means comprising n read heads, each having an output, for reading n information signals from the n tracks and supplying said information signals to the outputs,
- n detection means having inputs coupled to the outputs of the n read heads, for deriving n digital signals from the n information signals read from tracks and supplying said digital signals to outputs,
- n phase-locked loops having inputs coupled to the n outputs of the read heads,
each phase-locked loop comprising a phase comparator having a first input coupled to the input of the phase-locked loop, having a second input and having an output, a voltage-controlled oscillator having an input coupled to the output of the phase comparator and having an output for supplying a clock signal of a given frequency, which output is coupled to the second input of the phase comparator. Such arrangements are known, for example, in the form of magnetic-tape recorders of the SDAT type or the DCC type.

These recorders are capable of reading magnetic tapes on which digital audio has been recorded in a plurality of longitudinal tracks. This enables music reproduction of substantially CD quality to be achieved. The magnetic-tape recorder of the DCC type has come onto the market recently and is intended as a new digital cassette recorder standard to supersede the current Compact Cassette standard.

For the consumer market it has also been envisaged to provide such an apparatus for portable use and for use in car radios. This imposes additional requirements on the immunity of such apparatus to mechanical vibrations and shocks, in order to guarantee audio reproduction of substantially CD quality.

It is an object of the invention to provide an arrangement having an improved immunity to vibrations and shocks.

An arrangement as defined in the opening paragraph, further comprising a control signal generator for deriving from the n output signals of the phase comparators a control signal which is a measure of the deviation of the relative speed of transport of the record carrier with respect to the read means from the nominal relative speed of transport of the record carrier with respect to the read means, and for supplying said control signal to an output, and the arrangement further comprising means for applying the control signal to the inputs of the n voltage-controlled oscillators, the control signal generator comprising a signal combination unit having n inputs for receiving the n output signals of the n phase comparators, and having an output coupled to the output of the control signal generator *via* an integrating element, is disclosed in US-A 5,206,769.

The arrangement in accordance with the invention is characterized in that the control signal generator further comprises detection means having an input coupled to the output of the integrating element and having an output coupled to a control signal input of a controllable amplifier device, which controllable amplifier device is coupled between the output of the signal combination unit and the input of the integrating element.

The invention is based on the recognition of the following fact. For the clock extraction during readout of an information signal from a track on the record carrier a phase-locked loop is used. Mechanical vibrations and shocks result in variations of the relative speed of a read head with respect to the track. The phase-locked loop should have a bandwidth narrow enough to be immune to the noise present in the input signal applied to the loop and, conversely, the bandwidth should be so large that the loop is still capable of following the speed variations of the tape. In practice, an optimum bandwidth for the loop is determined for which the loop operates correctly. Nevertheless, it is found that the loop frequently comes out of lock in the case of shocks. However, a more limited bandwidth of the phase-locked loop again means that it is more difficult to track the normal speed variations of the tape. In order to extend the lock-in range of a phase-locked loop it is then known *per se* to add a frequency control loop.

In accordance with the present invention the output signal of the phase comparator, for each of the n tracks, is now applied to a common frequency control loop. Further, it is assumed that the speed variations are the same for all the tracks. Averaging the summed n phase errors yields a control signal which is a measure of the variation of the relative speed of transport of the record carrier with respect top the read means. The control signal, which may be regarded as a frequency control signal, is subsequently applied to the voltage-controlled oscillators of all the phase-locked loops. Since the information from all the n tracks is used it is possible to derive such a control signal that the loop responds more rapidly to speed variations.

By comparing in the detector the output signal of the detector with a threshold value and, when this threshold value is exceeded, applying to the controllable amplifier device a control signal to increase the gain the bandwidth of the frequency control loop is extended and a faster control is achieved.

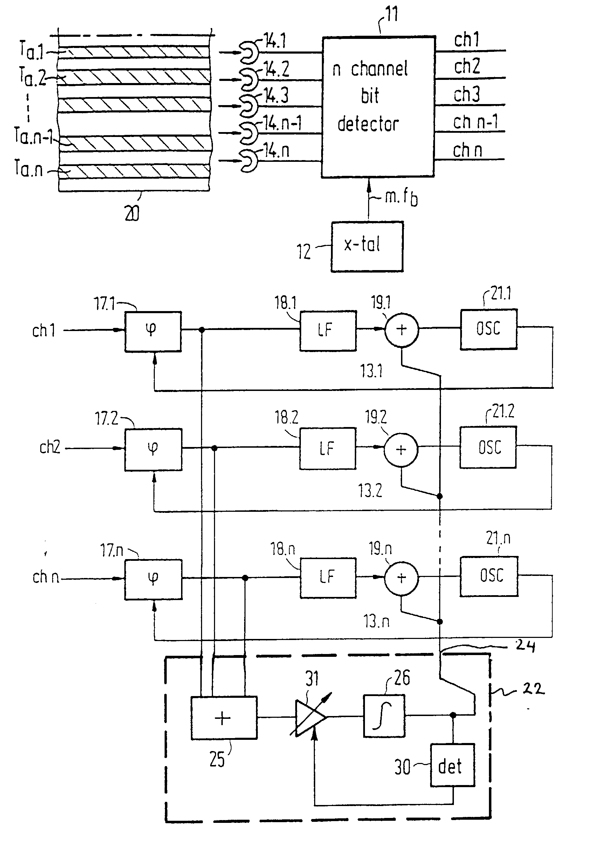

An embodiment of the invention will now be described in more detail, by way of example, in the figure.

The figure shows an arrangement intended for reading a digital signal from n tracks T_{a.1} to T_{a.n} which extend adjacent one another in the longitudinal direction of a magnetic record carrier 20 in the form of a tape. Only one half of the record carrier is shown. The arrangement has read means comprising n read heads 14.1 to 14.n which derive an analog signal from the n tracks. The n analog signals are applied to an n-channel bit detector 11. The analog signals are sampled and converted into a binary signal under the influence of a clock signal of a clock frequency m.f_{b} applied to the bit detector 11 by a fixed oscillator 12.

A clock frequency to be used for bit detection is derived from each of the n digital signals. To this end the resulting digital signals are applied to a phase-locked loop, n such loops 13.1 to 13.n being provided. For each channel ch i of the channels ch 1 to ch n the corresponding digital signal is applied to a first input of the phase comparator. The output of the phase comparator 17.i is coupled to the control signal input of a voltage-controlled oscillator 21.i, if required *via* a loop filter 18.i. The oscillator 21.i may be constructed as a discrete time oscillator.

The output of the oscillator 21.i is coupled to a second input of the phase comparator 17.i.

In accordance with the invention there is also provided a control signal generator 22. The control signal generator 22 is adapted to derive from the n output signals of the phase comparators 17.1 to 17.n and to supply to an output 24 a control signal which is measure of the deviation of the relative transport speed of the record carrier 20 with respect to the read means 14.1 to 14.n from the nominal relative transport speed of the record carrier 20 with respect to the read means. The arrangement further comprises means for applying the control signal to the input of the n voltage-controlled oscillators 21.1 to 21.n. For this purpose these means comprise signal combination units 19.1 to 19.n. The signal combination units may be constructed as adders and have a first input coupled to the output 24 of the control signal generator 22, a second input coupled to the output of a loop filter 18.i, and an output coupled to the control signal input of the oscillator 21.i.

The control signal generator 22 comprises a signal combination unit 25, an integrating element 26, a detector 30 and a controllable amplifier 31. The signal combination unit 25 has n inputs coupled to the outputs of the phase comparators 17.1 to 17.n. The output of the signal combination unit 25 is coupled to the input of the integrating element 26, via the controllable amplifier 31. The output of the integrating element 26 is coupled to the output 24 of the control signal generator 22, as well as to the input of the detector 30. The output of the detector 30 is coupled to a control signal input of the controllable amplifier 31 to control the gain factor of the amplifier 31 under the influence of the control signal. The detector 30 is adapted to detect whether the output signal of the integrating element 26 exceeds a given threshold value. If this value is exceeded this means that there is a certain frequency deviation which is to be eliminated more rapidly. This is achieved by additionally amplifying the output signal of the signal combination unit 25, so that a frequency control signal of larger amplitude can be applied to the voltage-controlled oscillators.

The invention has the advantage that the bandwidth of the phase-locked loops 13.i can be comparatively small because speed variations of the record carrier are handled by the additional control system, which may be regarded as a frequency control system.

Moreover, since the generator 22 uses n times as many signal transitions to determine the control signal, the signal-to-noise ratio of the control signal is higher.

The detector 30 preferably has a hysteresis in the threshold value such that, after the threshold value has been exceeded and the gain factor of the amplifier 31 has been increased, the threshold value is set to a lower level. This prevents the output signal of the integrating element 26 from oscillating, which would lead to an oscillation of the gain factor of the amplifier 31, the gain factor each time varying from a high to a low value.

The detector 30 preferably also has a delay such that, if the output signal of the integrating element 26 decreases below the threshold value, the gain factor of the amplifier 31 is reduced with a delay. Changing over to the higher value upon detection that the output signal of the integrating element 26 exceeds the threshold value is effected more or less instantaneously.

It is obvious that various implementations of the arrangement described herein are possible. In this respect it is to be noted that not all the elements as indicated in the circuit shown in the figure should be provided n times (or 2n times). The functions which can be time-multiplexed for the n channels then in principle require one element, which then operates in time multiplex.

It is to be noted also that the control signal supplied to the output 24 of the frequency detector 22 can be used as a control signal for the direct control of the tape-transport speed control system. This enables a rapidly operating transport-speed control to be realized.

## Claims

1. An arrangement for reproducing n digital signals from n adjacent tracks on a record carrier, which arrangement comprises
- read means comprising n read heads (14.1-14.n), each having an output, for reading n information signals from the n tracks and supplying said information signals to the outputs,
- n detection means (11) having inputs coupled to the outputs of the n read heads, for deriving n digital signals from the n information signals read from tracks and supplying said digital signals to outputs,
- n phase-locked loops (13.1-13.n) having inputs coupled to the n outputs of the read heads,
each phase-locked loop (13.i) comprising a phase comparator (17.i) having a first input coupled to the input of the phase-locked loop, having a second input and having an output, a voltage-controlled oscillator (21.i) having an input coupled to the output of the phase comparator and having an output for supplying a clock signal of a given frequency, which output is coupled to the second input of the phase comparator, the arrangement further comprising a control signal generator (22) for deriving from the n output signals of the phase comparators a control signal which is a measure of the deviation of the relative speed of transport of the record carrier with respect to the read means from the nominal relative speed of transport of the record carrier with respect to the read means, and for supplying said control signal to an output, and the arrangement further comprising means (19.1-19.n) for applying the control signal to the inputs of the n voltage-controlled oscillators, the control signal generator comprising a signal combination unit (25) having n inputs for receiving the n output signals of the n phase comparators, and having an output coupled to the output of the control signal generator *via* an integrating element (26), characterized in that the control signal generator further comprises detection means (30) having an input coupled to the output of the integrating element (26) and having an output coupled to a control signal input of a controllable amplifier device (31), which controllable amplifier device is coupled between the output of the signal combination unit (25) and the input of the integrating element (26).

## Patentansprüche

1. Anordnung zum Wiedergeben von n Digitalsignalen aus n benachbarten Spuren auf einem Aufzeichnungsträger, welche Anordnung umfaßt
- Lesemittel mit n Leseköpfen (14.1-14.n), von denen jeder einen Ausgang hat, zum Auslesen von n Informationssignalen aus den n Spuren und Abgeben der genannten Informationssignale an die Ausgänge,
- n Detektionsmittel (11) mit mit den Ausgängen der n Leseköpfe gekoppelten Eingängen, zum Ableiten von n Digitalsignalen aus den n aus Spuren ausgelesenen Informationssignalen und Abgeben der genannten Digitalsignale an Ausgänge,
- n Phasenregelschleifen (13.1-13.n) mit mit den n Ausgängen der Leseköpfe gekoppelten Eingängen,
wobei jede Phasenregelschleife (13.i) einen Phasenkomparator (17.i) umfaßt, der einen ersten mit dem Eingang der Phasenregelschleife gekoppelten Eingang hat, der einen zweiten Eingang und einen Ausgang hat, wobei ein spannungsgesteuerter Oszillator (21.i) einen mit dem Ausgang des Phasenkomparators gekoppelten Eingang hat und einen Ausgang zum Abgeben eines Taktsignals einer bestimmten Frequenz, welcher Ausgang mit dem zweiten Eingang des Phasenkomparators gekoppelt ist, wobei die Anordnung weiterhin einen Steuersignalgenerator (22) umfaßt, um aus den n Ausgangssignalen der Phasenkomparatoren ein Steuersignal abzuleiten, das ein Maß für die Abweichung der relativen Transportgeschwindigkeit des Aufzeichnungsträgers bezüglich der Lesemittel von der relativen Nenntransportgeschwindigkeit des Aufzeichnungsträgers bezüglich der Lesemittel ist, und zum Abgeben des genannten Steuersignals an einen Ausgang, und wobei die Anordnung weiterhin Mittel (19.1-19.n) zum Zuführen des Steuersignals an die Eingänge der n spannungsgesteuerten Oszillatoren umfaßt, wobei der Steuersignalgenerator eine Signalkombinationseinheit (25) mit n Eingängen zum Empfangen der n Ausgangssignale der n Phasenkomparatoren umfaßt, und mit einem über ein integrierendes Element (26) an den Ausgang des Steuersignalgenerators gekoppelten Ausgang, dadurch gekennzeichnet, daß der Steuersignalgenerator weiterhin Detektionsmittel (30) mit einem mit dem Ausgang des integrierenden Elementes (26) gekoppelten Eingang und mit einem mit einem Steuersignaleingang einer steuerbaren Verstärkeranordnung (31) gekoppelten Ausgang umfaßt, welche steuerbare Verstärkeranordnung zwischen den Ausgang der Signalkombinationseinheit (25) und den Eingang des integrierenden Elementes (26) geschaltet ist.

## Revendications

1. Dispositif de lecture de n signaux numériques de n pistes adjacentes sur un support d'enregistrement, ledit dispositif comprenant :
- des moyens de lecture comprenant n têtes de lecture (14.1 à 14.n), chacune d'elles ayant une sortie, pour lire n signaux d'information des n pistes et délivrer lesdits signaux d'information aux sorties,
- n moyens de détection (11) ayant des entrées connectées aux sorties des n têtes de lecture, pour dériver n signaux numériques des n signaux d'information lus sur les pistes et pour fournir lesdits signaux numériques aux sorties,
- n boucles à verrouillage de phase (13.1 à 13.n) ayant des entrées connectées aux n sorties des têtes de lecture, chaque boucle à verrouillage de phase (13.i) comprenant un comparateur de phase (17.i) ayant une première entrée connectée à l'entrée de la boucle à verrouillage de phase, ayant une deuxième entrée et ayant une sortie, un oscillateur commandé en tension (21.i) ayant une entrée connectée à la sortie du comparateur de phase et ayant une sortie servant à délivrer un signal d'horloge d'une fréquence donnée, ladite sortie étant raccordée à la deuxième entrée du comparateur de phase, le dispositif comprenant en plus un générateur de signaux de commande (22) pour dériver des n signaux de sortie des comparateurs de phase un signal de commande qui soit une mesure de l'écart entre la vitesse relative de défilement du support d'enregistrement par rapport aux moyens de lecture et la vitesse relative nominale de défilement du support d'enregistrement par rapport auxdits moyens de lecture, et pour envoyer ledit signal de commande à une sortie, et le dispositif comprenant en outre des moyens (19.1 à 19.n) pour appliquer le signal de commande aux entrées des n oscillateurs commandés en tension, le générateur de signaux de commande comprenant une unité de combinaison de signaux (25) ayant n entrées pour recevoir les n signaux de sortie des n comparateurs de phase, et ayant une sortie connectée à la sortie du générateur de signaux de commande via un élément d'intégration (26), caractérisé en ce que le générateur de signaux de commande comprend en outre des moyens de détection (30) ayant une entrée connectée à la sortie de l'élément d'intégration (26) et ayant une sortie connectée à une entrée de signal de commande d'une unité d'amplification pouvant être commandée (31), ladite unité d'amplification pouvant être commandée étant connectée entre la sortie de l'unité de combinaison de signaux (25) et l'entrée de l'élément d'intégration (26).
